# EUROPÄISCHE PATENTSCHRIFT

(11) **EP 2 754 244 B1**
(45) Veröffentlichungstag und Bekanntmachung des Hinweises auf die Patenterteilung: **09.11.2016**
(21) Anmeldenummer: 12766919.0
(22) Anmeldetag: 03.09.2012
(51) Int. Cl.: H03K 17/965

(54) **BEDIENEINRICHTUNG**
OPERATING DEVICE
DISPOSITIF DE COMMANDE

(30) Priorität: 05.09.2011 DE 102011082142
(43) Veröffentlichungstag der Anmeldung: 16.07.2014
(73) Patentinhaber: Continental Automotive GmbH, 30165 Hannover (DE)
(72) Erfinder: KERN, Thorsten Alexander, 64665 Alsbach (DE); ZOLLER, Ingo, 63768 Hösbach (DE)
(86) Internationale Anmeldenummer: PCT/EP2012/067050
(87) Internationale Veröffentlichungsnummer: WO 2013/034507

(56) Entgegenhaltungen:
- EP-A2- 2 244 167
- EP-A2- 2 244 168
- US-A- 5 189 390
- US-A1- 2002 033 795
- US-A1- 2010 238 053
- US-B1- 6 982 696

## Beschreibung

Die Erfindung bezieht sich auf eine Bedieneinrichtung für ein elektrisches Gerät, mit einem Betätigungselement mit haptischer Rückmeldung, das eine berührungssensitive Bedienfläche aufweist, wobei das Betätigungselement von einer Bedienperson mittels eines Eingabeorgans betätigbar und ein Betätigungssignal auslösbar ist und wobei das Betätigungselement um eine Schwenkachse zwischen einer Ruhelage und einer Schaltlage schwenkbar gelagert ist.

Haptische Rückmeldungen von Bedienelementen werden vor allem dann gefordert, wenn eine Bedienperson den von ihr ausgeführten Bedienvorgang nicht direkt wahrnehmen kann. Während bei Bedienvorrichtungen mit elektromechanischen Schaltern für die Bedienperson das Öffnen oder Schließen der Schaltkontakte durch eine sich ändernde Haptik des Bedienelements wahrnehmbar ist, ist dies bei elektronischen Schaltern nicht notwendigerweise vorhanden. Deshalb sind im Stand der Technik Bedienelemente bekannt, die mittels für die Bedienperson wahrnehmbaren Bewegungen des Bedienelements eine haptische Rückmeldung über einen erfolgten Bedienvorgang geben. Die bekannten haptischen Bedienelemente beispielsweise für sogenannte Touchscreens erfordern einen großen Bauraum, einen aufwendigen Antrieb und besondere konstruktive Maßnahmen, wenn diese beispielsweise in einem Umfeld eingesetzt werden sollen, das von besonders großen Temperaturunterschieden geprägt ist, wie es beispielsweise in einem Kraftfahrzeug der Fall ist, welches sowohl in arktischer Kälte als auch in sommerlicher Hitze seine Funktionsfähigkeit erhalten muss.

Die US 6,982,696 B1 beschreibt eine Bedieneinrichtung mit den Merkmalen des Oberbegriffs des Patentanspruchs 1.

Aufgabe der Erfindung ist es, eine Bedieneinrichtung der eingangs genannten Art zu schaffen, die einen einfachen, bauraumsparenden Aufbau aufweist und eine eindeutig erfassbare haptische Rückmeldung erzeugt.

Diese Aufgabe wird erfindungsgemäß durch eine Bedieneinrichtung mit den Merkmalen des Anspruchs 1 gelöst.

Durch diese Ausbildung erhält die Bedienperson bei einem schwenkbar gelagerten Betätigungselement nach Erfassung einer Betätigung mittels des Eingabeorgans, vorzugsweise eines Fingers der Bedienperson, eine haptische Rückmeldung, indem die Betätigung der Bedienperson in ihrem Momentverlauf unterstützt oder entgegengesetzt angesteuert wird.

Zu einer bidirektionalen Rückmeldung führt es, wenn durch das Betätigungssignal ein zweiter elektromagnetischer Aktuator ein zweites Magnetfeld erzeugend ansteuerbar ist, durch das das rotatorisch gelagerte, magnetisch beeinflussbare Element aus der Ausgangslage in eine zweite Schwenklage bewegbar ist, wobei durch die Bewegung des rotatorisch gelagertes, magnetisch beeinflussbaren Elements direkt oder indirekt ein das Betätigungselement aus der Ruhelage in eine zweite Schaltlage bewegendes Moment auf das Betätigungselement einwirkbar ist. Weiterhin führt es zu einem einfachen kompakten und kostengünstigen Aufbau.

Durch das erste und/oder zweite magnetisch beeinflussbare Element kann das auf das Betätigungselement einwirkbare Moment dem durch das Eingabeorgan auf das Betätigungselement einwirkbaren Moment gleichgerichtet oder entgegengesetzt sein.

Zur Verbesserung des magnetischen Flusses kann von der ersten zur zweiten Polschuhplatte ein freies Ende der ersten Polschuhplatte ein nahe zu einem freien Ende der zweiten Polschuhplatte führendes flussleitendes Element aufweisen.

Für eine bidirektionale Rückmeldung kann der zweite elektromagnetische Aktuator eine dritte Polschuhplatte aufweisen, der der das magnetisch beeinflussbare Element bildenden zweiten Polschuhplatte in einem Abstand annähernd parallel gegenüber liegt, wobei zwischen der dritten und zweiten Polschuhplatte eine ein senkrecht zur Ebene der dritten Polschuhplatte gerichtetes Magnetfeld erzeugende zweite Spule angeordnet ist, die der dritten Polschuhplatte zugeordnet ist und wobei die zweite Polschuhplatte zwischen der ersten Polschuhplatte und der dritten Polschuhplatte angeordnet ist, wobei die erste Polschuhplatte und die dritte Polschuhplatte zur Verbesserung des magnetischen Flusses durch ein Flussleitelement verbunden sein können.

Weist die erste Polschuhplatte einen zur zweiten Polschuhplatte gerichteten ersten Spulenkern auf, dem die erste Spule zugeordnet ist und/oder die dritte Polschuhplatte einen zur zweiten Polschuhplatte gerichteten zweiten Spulenkern aufweist, dem die zweite Spule zugeordnet ist, so wird der von den Spulen erzeugte magnetische Fluss gerichtet und die Krafteinwirkung zwischen den Polschuhplatten weiter erhöht.

Dabei kann die erste Spule den ersten Spulenkern und/oder die zweite Spule den zweiten Spulenkern umschließen.

Zu einem besonders flachen und damit bauraumsparenden Aufbau führt es, wenn die erste Spule und/oder die zweite Spule Flachspulen aus auf einer Leiterplatte aufgebrachten Leiterbahnen sind.

Zu einer gut erfassbaren Rückmeldung führt es, wenn das Betätigungselement ein um die Schwenkachse schwenkbar gelagerter zweiarmiger Hebel ist, an dessen einem Hebelarm die von dem Eingabeorgan beaufschlagbare Bedienfläche angeordnet ist.

Dabei ist ein kompakter Aufbau mit wenigen Bauteilen erreichbar, wenn das magnetisch beeinflussbare Element fest mit dem zweiten Hebelarm des Betätigungselements verbunden ist.

Eine kompakte Bautiefe mit gleichzeitig sehr flachem Aufbau wird dadurch erreicht, dass die zweite Polschuhplatte um eine zur ersten Schwenkachse parallele zweite Schwenkachse schwenkbar gelagert ist und in einem Abstand zur zweiten Schwenkachse an einer Anlenkstelle des Betätigungselements angelenkt ist, die in einem Abstand zur ersten Schwenkachse angeordnet ist.

Dabei können zur bidirektionalen Rückmeldung der ersten Polschuhplatte zwei elektromagnetische Aktuatoren zugeordnet sein, wobei auf jeder Seite der zweiten Schwenkachse ein Aktuator angeordnet ist.

Dabei können bauteilsparend die Spulen beider Aktuatoren auf einer gemeinsamen Leiterplatte angeordnet sein.

Nach einer Ansteuerung des elektromagnetischen Akuators erfolgt auf einfache Weise ein Zurückstellen des magnetisch beeinflussbaren Elements in seiner Ausgangslage, wenn das rotatorisch gelagerte, magnetisch beeinflussbare Element entgegen einer Federkraft aus seiner Ausgangslage in seine Schwenklage bewegbar ist.

Es ist aber auch möglich, dass das rotatorisch gelagerte, magnetisch beeinflussbare Element in seiner ersten und/oder zweiten Schwenklage kraftschlüssig haltbar ist und erst durch manuelle Betätigung des Betätigungselements oder durch Ansteuerung eines in Richtung der Ausgangslage ansteuerbaren Aktuators in die Ausgangslage zurückgestellt wird.

Ausführungsbeispiele der Erfindung sind in der Zeichnung dargestellt und werden im Folgenden näher beschrieben. Es zeigen:
- Figur 1: eine Seitenansicht eines ersten Ausführungsbeispiels einer Bedieneinrichtung;
- Figur 2: eine Seitenansicht eines zweiten Ausführungsbeispiels einer Bedieneinrichtung;
- Figur 3: eine Seitenansicht eines dritten Ausführungsbeispiels einer Bedieneinrichtung und
- Figur 4: eine Seitenansicht eines vierten Ausführungsbeispiels einer Bedieneinrichtung.

Die dargestellten Bedieneinrichtungen weisen einen zweiarmigen Hebel 1 auf, der um eine erste Schwenkachse 2 schwenkbar gelagert ist.

Ein erster Hebelarm des Hebels 1 weist eine von einem Eingabeorgan, insbesondere einem Finger einer Hand einer Bedienperson beaufschlagbare Bedienfläche 3 auf.

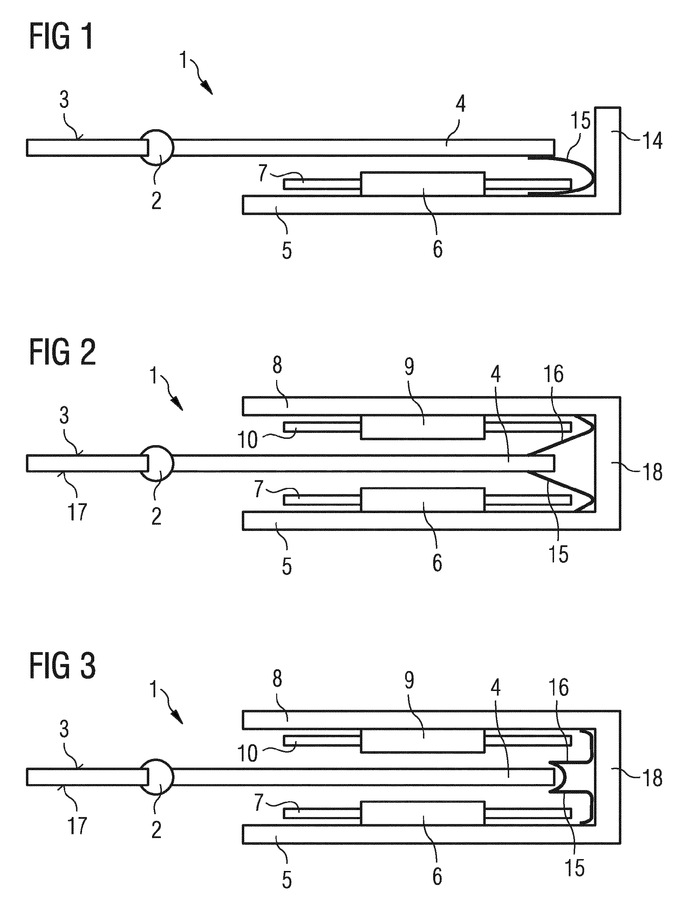

In den Figuren 1 bis 3 bildet ein zweiter Hebelarm des Hebels 1 eine aus einem ferromagnetischen Werkstoff bestehende zweite Polschuhplatte 4.

Der zweiten Polschuhplatte 4 liegt in einem Abstand annähernd parallel eine ebenfalls aus einem ferromagnetischen Werkstoff bestehende erste Polschuhplatte 5 gegenüber, die einen zur zweiten Polschuhplatte 4 gerichteten ersten Spulenkern 6 aufweist.

Zwischen der ersten Polschuhplatte 5 und der zweiten Polschuhplatte 4 ist parallel zu diesen eine erste Leiterplatte 7 angeordnet, die eine Öffnung aufweist, durch die der erste Spulenkern 6 hindurchragt.

Auf der ersten Leiterplatte 7 ist eine nicht dargestellte erste Flachspule angeordnet, die den ersten Spulenkern 6 umschließt und aus auf die erste Leiterplatte 7 aufgebrachten Leiterbahnen besteht.

Bei den Ausführungsbeispielen der Figuren 2 und 3 ist auf der der ersten Polschuhplatte 5 abgewandten Seite der zweiten Polschuhplatte 4 ebenfalls in einem Abstand und parallel zu dieser eine aus einem ferromagnetischen Werkstoff bestehende dritte Polschuhplatte 8 angeordnet, die einen zur zweiten Polschuhplatte 4 gerichteten zweiten Spulenkern 9 aufweist. Zwischen der dritten Polschuhplatte 8 und der zweiten Polschuhplatte 4 ist parallel zu diesen eine zweite Leiterplatte 10 angeordnet, die eine Öffnung aufweist, durch die der zweite Spulenkern 9 hindurchragt.

Auf der zweiten Leiterplatte 10 ist auf gleiche Weise wie auf der ersten Leiterplatte 7 eine zweite Flachspule angeordnet.

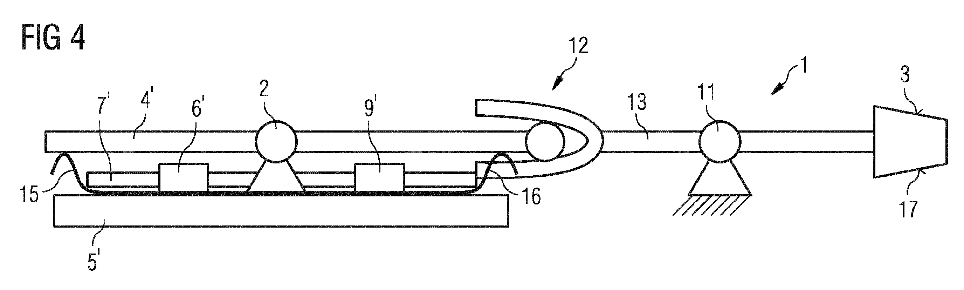

In Figur 4 ist eine aus einem ferromagnetischen Werkstoff bestehende zweite Polschuhplatte 4' annähernd mittig um eine erste Schwenkachse 2 schwenkbar gelagert und an ihrem einen Ende zu dem sich annähernd in gleicher Ebene erstreckenden Hebel 1 über eine Anlenkstelle mit einem zweiten Hebelarm 13 des Hebels 1 gelenkig verbunden, der um eine zur ersten Schwenkachse 2 parallele zweite Schwenkachse 11 schwenkbar gelagert ist.

In einem Abstand und annähernd parallel zur zweiten Polschuhplatte 4' ist eine aus einem ferromagnetischen Werkstoff bestehende erste Polschuhplatte 5' angeordnet, die auf der einen Seite in einem Abstand zur zweiten Schwenkachse 11 einen ersten Spulenkern 6' und auf der anderen Seite in einem Abstand zu zweiten Schwenkachse 11 einen zweiten Spulenkern 9 aufweist.

Zwischen der ersten Polschuhplatte 5' und der zweiten Polschuhplatte 4' ist parallel zu diesen eine erste Leiterplatte 7' angeordnet, die Öffnungen aufweist, durch die der erste und zweite Spulenkern 6', 9' hindurchragen.

Auf der ersten Leiterplatte 7' sind entsprechend den Figuren 1 bis 3 den ersten Spulenkern 6' eine erste Flachspule umschließend und den zweiten Spulenkern 9' eine zweite Flachspule umschließend angeordnet.

Bei dem Ausführungsbeispiel der Figur 1 weist die erste Polschuhplatte 5 an ihrem einen Ende ein bis nahe an das eine Ende der zweiten Polschuhplatte 4 führendes flussleitendes Element 14 auf, während bei den Ausführungsbeispielen der Figuren 2 und 3 die einen Enden der ersten und dritten Polschuhplatte 5 und 8 durch ein Flussleitelement 18 miteinander verbunden sind.

Bei allen Ausführungsbeispielen sind die zweiten Polschuhplatten 4, 4' entgegen einer Federkraft aus ihrer dargestellten Ausgangslage in ihre Schwenklage bewegbar, wenn die Berührungssensitive Bedienfläche 3 betätigt und ein Betätigungssignal ausgelöst wird, von dem die jeweilige Flachspule bestromt und ein Magnetfeld erzeugt wird.

Dabei wird bei dem Ausführungsbeispiel der Figur 1 durch das Magnetfeld die zweite Polschuhplatte 4 entgegen der Kraft eines ersten Federelements 15 bis nahe an den ersten Spulenkern 6 angezogen, so daß der Hebel 1 um die erste Schwenkachse 2 in seiner Schwenklage schwenkt, was der Beaufschlagung der Bedienfläche 3 entgegenwirkt und von der Bedienperson haptisch erfasst wird. Bei den Ausführungsbeispielen der Figuren 2 bis 4 erfolgt bei Beaufschlagung der Bedienfläche 3 die gleiche Funktion.

Bei Beaufschlagung der der Bedienfläche 3 entgegengesetzt angeordneten zweiten Bedienfläche 17 wird die den zweiten Spulenkern 9, 9' zugeordnete Flachspule bestromt und die zweite Polschuhplatte 4, 4' entgegen der Kraft eines zweiten Federelements 16 bis nahe an den zweiten Spulenkern 9, 9' angezogen, so dass der Hebel 1 in die entgegengesetzte Richtung um die erste Schwenkachse 2 in eine zweite Schwenklage schwenkt, was der Beaufschlagung der zweiten Bedienfläche 17 entgegenwirkt und von der Bedienperson haptisch erfasst wird.

Dabei wird bei dem Ausführungsbeispiel der Figur 3 die zweite Polschuhplatte 4 in ihrer ersten oder zweiten Schwenklage durch das erste oder zweite Federelement 15 und 16 gehalten, bis entweder durch manuelle Beaufschlagung des Hebels 1 oder durch kurze Ansteuerung der entgegengesetzten Flachspule ein Rückstellen des Magnetfelds erzeugt wird.

In Figur 4 erfolgt die Übertragung der Schwenkbewegung der zweiten Polschuhplatte 4' über die Anlenkstelle 12 auf den Hebel 1.

## Patentansprüche

1. *Bedieneinrichtung* für ein elektrisches Gerät, mit einem Betätigungselement mit haptischer Rückmeldung, das eine berührungssensitive Bedienfläche (3) aufweist, wobei das Betätigungselement von einer Bedienperson mittels eines Eingabeorgans betätigbar und ein Betätigungssignal auslösbar ist und wobei das Betätigungselement um eine erste Schwenkachse (2, 11) zwischen einer Ruhelage und einer Schaltlage schwenkbar gelagert ist, wobei durch das Betätigungssignal ein erster elektromagnetischer Aktuator (5, 5', 6, 6', 7, 7) ein Magnetfeld erzeugend ansteuerbar ist, durch das ein rotatorisch gelagertes, magnetisch beeinflussbares Element (4, 4') aus einer Ausgangslage in eine Schwenklage bewegbar ist, d a du r c h gekennzeichnet, dass durch die Bewegung des rotatorisch gelagerten, magnetisch beeinflussbaren Elements (4) direkt oder indirekt ein das Betätigungselement aus der Ruhelage in die Schaltlage bewegendes Moment auf das Betätigungselement einwirkbar ist,wobei der erste elektromagnetische Aktuator eine erste Polschuhplatte (5, 5') aufweist, der einer das rotatorisch gelagerte magnetisch beeinflussbare Element bildende zweiten Polschuhplatte (4, 4') in einem Abstand parallel gegenüber liegt, wobei zwischen der ersten und zweiten Polschuhplatte (5, 5', 4, 4') eine ein senkrecht zur Ebene der ersten Polschuhplatte (5, 5') gerichtetes Magnetfeld erzeugende Spule angeordnet ist, die der ersten Polschuhplatte (5, 5') zugeordnet ist.

2. Bedieneinrichtung nach Anspruch 1, **dadurch gekennzeichnet, dass** durch das Betätigungssignal ein zweiter elektromagnetischer Aktuator (8,9, 10) ein zweites Magnetfeld erzeugend ansteuerbar ist, durch das das rotatorisch gelagerte, magnetisch beeinflussbare Element (4) aus der Ausgangslage in eine zweite Schwenklage bewegbar ist, wobei durch die Bewegung des magnetisch beeinflussbaren Elements (4) direkt oder indirekt ein das Betätigungselement aus der Ruhelage in eine zweite Schaltlage bewegendes Moment auf das Betätigungselement einwirkbar ist.

3. Bedieneinrichtung nach einem der vorhergehenden Ansprüche, **dadurch gekennzeichnet, dass** das durch das erste und/oder zweite magnetisch beeinflussbare Element (4, 4') auf das Betätigungselement einwirkbare Moment dem durch das Eingabeorgan auf das Betätigungselement einwirkbaren Moment gleichgerichtet oder entgegengesetzt ist.

4. Bedieneinrichtung nach einem der vorhergehenden Ansprüche, **dadurch gekennzeichnet, dass** der zweite elektromagnetische Aktuator eine dritte Polschuhplatte (8) aufweist, der der das magnetisch beeinflussbare Element bildenden zweiten Polschuhplatte (4) in einem Abstand parallel gegenüber liegt, wobei zwischen der dritten und zweiten Polschuhplatte (8, 4) eine ein senkrecht zur Ebene der dritten Polschuhplatte (8) gerichtetes Magnetfeld erzeugende zweite Spule angeordnet ist, die der dritten Polschuhplatte (8) zugeordnet ist und wobei die zweite Polschuhplatte (4) zwischen der ersten Polschuhplatte (5) und der dritten Polschuhplatte (8) angeordnet ist.

5. Bedieneinrichtung nach Anspruch 4, **dadurch gekennzeichnet, dass** die erste Polschuhplatte (5, 5') einen zur zweiten Polschuhplatte (4, 4') gerichteten ersten Spulenkern (6, 6') aufweist, dem die erste Spule zugeordnet ist und/oder die dritte Polschuhplatte (8) einen zur zweiten Polschuhplatte (4) gerichteten zweiten Spulenkern (9) aufweist, dem die zweite Spule zugeordnet ist.

6. Bedieneinrichtung nach Anspruch 5, **dadurch gekennzeichnet, dass** die erste Spule den ersten Spulenkern (6, 6') und/oder die zweite Spule den zweiten Spulenkern (9) umschließt.

7. Bedieneinrichtung nach Anspruch 6, **dadurch gekennzeichnet, dass** die erste Spule und/oder die zweite Spule Flachspulen aus auf einer Leiterplatte (7, 10) aufgebrachten Leiterbahnen sind.

8. Bedieneinrichtung nach einem der vorhergehenden Ansprüche, **dadurch gekennzeichnet, dass** das Betätigungselement ein um die Schwenkachse (2) schwenkbar gelagerter zweiarmiger Hebel (1) ist, an dessen einem Hebelarm der von dem Eingabeorgan beaufschlagbare Bedienfläche (3, 17) angeordnet ist.

9. Bedieneinrichtung Anspruch 8, **dadurch gekennzeichnet, dass** das magnetisch beeinflussbare Element (4) fest mit dem zweiten Hebelarm des Betätigungselements verbunden ist.

10. Bedieneinrichtung nach einem der Ansprüche 3 bis 8, **dadurch gekennzeichnet, dass** die zweite Polschuhplatte (4') um eine zur ersten Schwenkachse (2) parallele zweite Schwenkachse (11) schwenkbar gelagert ist und in einem Abstand zur zweiten Schwenkachse (11) an einer Anlenkstelle (12) des Betätigungselements angelenkt ist, die in einem Abstand zur ersten Schwenkachse (2) angeordnet ist.

11. Bedieneinrichtung nach Anspruch 10, **dadurch gekennzeichnet, dass** der ersten Polschuhplatte (5') zwei elektromagnetische Aktuatoren (5', 6', 7', 9') zugeordnet sind, wobei auf jeder Seite der ersten Schwenkachse (2) ein Aktuator (5', 6', 7', 9') angeordnet ist.

12. Bedieneinrichtung nach einem der vorhergehenden Ansprüche, **dadurch gekennzeichnet, dass** das rotatorisch gelagerte, magnetisch beeinflussbare Element (4, 4') entgegen einer Federkraft aus seiner Ausgangslage in seine Schwenklage bewegbar ist.

13. Bedieneinrichtung nach einem der vorhergehenden Ansprüche, **dadurch gekennzeichnet, dass** das rotatorisch gelagerte, magnetisch beeinflussbare Element (4, 4') in seiner ersten und/oder zweiten Schwenklage kraftschlüssig haltbar ist.

## Claims

1. Operator control device for an electrical apparatus, having an activation element with haptic feedback, which activation element has a touch-sensitive operator control surface (3), wherein the activation element can be activated by an operator by means of an input member and an activation signal can be triggered, and wherein the activation element is mounted so as to be pivotable about a first pivoting axis (2, 11) between a position of rest and a switching position, wherein a first electromagnetic actuator (5, 5', 6, 6', 7, 7) can be actuated by the activation signal so as to generate a magnetic field which moves a rotationally mounted, magnetically influenceable element (4, 4') from an initial position into a pivoting position, **characterized in that**, as a result of movement of the rotationally mounted, magnetically influenceable element (4), a torque which moves the activation element out of the position of rest into the switching position can be applied directly or indirectly to the activation element, wherein the first electro-magnetic actuator has a first pole shoe plate (5, 5') opposite which, in parallel and at a distance, there is a second pole shoe plate (4, 4') which forms the rotationally mounted, magnetically influenceable element, wherein a coil which generates a magnetic field which is directed perpendicularly with respect to the plane of the first pole shoe plate (5, 5') and which is assigned to the first pole shoe plate (5, 5') is arranged between the first and second pole shoe plates (5, 5', 4, 4').

2. Operator control device according to Claim 1, **characterized in that** the activation signal can actuate a second electromagnetic actuator (8, 9, 10) so as to generate a second magnetic field which can move the rotationally mounted, magnetically influenceable element (4) out of the initial position into a second pivoting position, wherein as a result of the movement of the magnetically influenceable element (4) a torque which moves the activation element out of the position of rest into a second switching position can be applied directly or indirectly to the activation element.

3. Operator control device according to one of the preceding claims, **characterized in that** the torque which can act on the activation element by means of the first and/or second magnetically influenceable element (4, 4') is in the same or the opposite direction to the torque which can act on the activation element by means of the input member.

4. Operator control device according to one of the preceding claims, **characterized in that** the second electromagnetic actuator has a third pole shoe plate (8) opposite which, in parallel and at a distance, there is the second pole shoe plate (4) which forms the magnetically influenceable element, wherein a second coil, which generates a magnetic field which is directed perpendicularly with respect to the plane of the third pole shoe plate (8) and which is assigned to the third pole shoe plate (8) is arranged between the third and second pole shoe plates (8, 4), and wherein the second pole shoe plate (4) is arranged between the first pole shoe plate (5) and the third pole shoe plate (8).

5. Operator control device according to Claim 4, **characterized in that** the first pole shoe plate (5, 5') has a first coil former (6, 6') which is directed toward the second pole shoe plate (4, 4') and to which the first coil is assigned, and/or the third pole shoe plate (8) has a second coil former (9) which is directed toward the second pole shoe plate (4) and to which the second coil is assigned.

6. Operator control device according to Claim 5, **characterized in that** the first coil surrounds the first coil former (6, 6'), and/or the second coil surrounds the second coil former (9).

7. Operator control device according to Claim 6, **characterized in that** the first coil and/or the second coil are flat coils composed of conductor tracks applied to a printed circuit board (7, 10).

8. Operator control device according to one of the preceding claims, **characterized in that** the activation element is a two-armed lever (1) which is mounted so as to be pivotable about the pivoting axis (2) and on whose one lever arm the operator control surface (3, 17) on which the input member can act, is arranged.

9. Operator control device according to Claim 8, **characterized in that** the magnetically influenceable element (4) is permanently connected to the second lever arm of the activation element.

10. Operator control device according to one of Claims 3 to 8, **characterized in that** the second pole shoe plate (4') is mounted so as to be pivotable about a second pivoting axis (11) which is parallel to the first pivoting axis (2), and said second pole shoe plate (4') is coupled in articulated fashion at an articulation point (12) of the activation element at a distance from the second pivoting axis (11), said articulation point being arranged at a distance from the first pivoting axis (2).

11. Operator control device according to Claim 10, **characterized in that** two electromagnetic actuators (5', 6', 7', 9') are assigned toral the first pole shoe plate (5'), wherein an actuator (5', 6', 7', 9') is arranged on each side of the first pivoting axis (2).

12. Operator control device according to one of the preceding claims, **characterized in that** the
rotatably mounted magnetically influenceable element (4, 4') can be moved out of its initial position into its pivoting position counter to a spring force.

13. Operator control device according to one of the preceding claims, **characterized in that** the rotatably mounted, magnetically influenceable element (4, 4') is secured in a frictionally locking fashion in its first and/or second pivoting position.

## Revendications

1. Dispositif de commande d'un appareil électrique, avec un élément de manoeuvre avec rétrosignal haptique, qui comporte une surface de commande (3) tactile, l'élément de manoeuvre étant susceptible d'être manoeuvré par un opérateur au moyen d'un organe de saisie et un signal de manoeuvre pouvant être déclenché et l'élément de manoeuvre étant logé en étant susceptible de pivoter autour d'un premier axe de pivotement (2, 11) entre une position de repos et une position de commutation, par le signal de manoeuvre, un premier actionneur (5, 5', 6, 6', 7, 7') électromagnétique étant susceptible d'être activé en générant un champ magnétique par le biais du signal de manoeuvre, par lequel un élément (4, 4') logé en rotation, magnétiquement influençable est déplaçable d'une position initiale dans une position pivotée, **caractérisé en ce que** par le déplacement de l'élément (4) logé en rotation, magnétiquement influençable, directement ou indirectement, un couple déplaçant l'élément de manoeuvre de la position de repos dans la position de commutation est susceptible d'influencer l'élément de manoeuvre, le premier actionneur électromagnétique comportant une première plaque à pièces polaires (5, 5') qui est opposée à la parallèle avec un écart à une deuxième plaque à pièces polaires (4, 4') formant l'élément logé en rotation, magnétiquement influençable, entre la première et la deuxième plaque à pièces polaires (5, 5', 4, 4') étant placée une bobine créant un champ magnétique dirigé à la perpendiculaire du plan de la première plaque à pièces polaires (5, 5'), qui est associée à la première plaque à pièces polaires (5, 5').

2. Dispositif de commande selon la revendication 1, **caractérisé en ce que** par le signal de manoeuvre, un deuxième actionneur (8, 9, 10) électromagnétique créant un deuxième champ magnétique est activable, par lequel l'élément (4) logé en rotation, magnétiquement influençable est déplaçable de la position initiale dans une deuxième position pivotée, par le déplacement de l'élément (4) magnétiquement influençable, directement ou indirectement, un couple déplaçant l'élément de manoeuvre de la position de repos dans une deuxième position de commutation étant susceptible d'influencer l'élément de manoeuvre.

3. Dispositif de commande selon l'une quelconque des revendications précédentes, **caractérisé en ce que** le couple susceptible d'influencer l'élément de manoeuvre via le premier et ou le deuxième élément (4, 4') magnétiquement influençable est dirigé dans le même sens que ou en sens inverse du couple susceptible d'influencer l'élément de manoeuvre via l'organe de saisie.

4. Dispositif de commande selon l'une quelconque des revendications précédentes, **caractérisé en ce que** le deuxième actionneur électromagnétique comporte une troisième plaque à pièces polaires (8) qui est opposée parallèlement avec un écart à la deuxième plaque à pièces polaires (4) formant l'élément magnétiquement influençable, entre la troisième et la deuxième plaque à pièces polaires (8, 4) étant placée une deuxième bobine créant un champ magnétique dirigé à la perpendiculaire du plan de la troisième plaque à pièces polaires (8), qui est associée à la troisième plaque à pièces polaires (8) et la deuxième plaque à pièces polaires (4) étant placée entre la première plaque à pièces polaires (5) et la troisième plaque à pièces polaires (8).

5. Dispositif de commande selon la revendication 4, **caractérisé en ce que** la première plaque à pièces polaires (5, 5') comporte un premier noyau de bobine (6, 6') dirigé vers la deuxième plaque à pièces polaires (4, 4'), auquel est associée la première bobine et/ou la troisième plaque à pièces polaires (8) comporte un deuxième noyau de bobine (9) dirigé vers la deuxième plaque à pièces polaires (4) auquel est associée la deuxième bobine.

6. Dispositif de commande selon la revendication 5, **caractérisé en ce que** la première bobine entoure le premier noyau de bobine (6, 6') et/ou la deuxième bobine entoure le deuxième noyau de bobine (9).

7. Dispositif de commande selon la revendication 6, **caractérisé en ce que** la première bobine et/ou la deuxième bobine sont des bobines plates constituées de pistes conductives appliquées sur une carte de circuit imprimé (7, 10).

8. Dispositif de commande selon l'une quelconque des revendications précédentes, **caractérisé en ce que** l'élément de manoeuvre est un levier (1) à deux bras logé en étant susceptible de pivoter autour de l'axe de pivotement (2) sur l'un des bras de levier duquel est placée une surface de commande (3, 17) susceptible d'être soumise à l'organe de saisie.

9. Dispositif de commande selon la revendication 8, **caractérisé en ce que** l'élément (4) magnétiquement influençable est fixement relié avec le deuxième bras de levier de l'élément de manoeuvre.

10. Dispositif de commande selon l'une quelconque des revendications 3 à 8, **caractérisé en ce que** la deuxième plaque à pièces polaires (4') est logée en étant susceptible de pivoter autour d'un deuxième axe de pivotement (11) parallèle au premier axe de pivotement (2) et est articulée avec un écart par rapport au deuxième axe de pivotement (11) sur un point d'articulation (12) de l'élément de manoeuvre, qui est placé avec un écart par rapport au premier axe de pivotement (2).

11. Dispositif de commande selon la revendication 10, **caractérisé en ce qu'**à la première plaque à pièces polaires (5') sont associés deux actionneurs (5', 6', 7', 9') électromagnétiques, sur chaque côté du premier axe de pivotement (2) étant placé un actionneur (5', 6', 7', 9').

12. Dispositif de commande selon l'une quelconque des revendications précédentes, **caractérisé en ce que** l'élément (4, 4') logé en rotation, magnétiquement influençable est déplaçable à l'encontre d'une force de ressort de sa position initiale dans sa position pivotée.

13. Dispositif de commande selon l'une quelconque des revendications précédentes, **caractérisé en ce que** l'élément (4, 4') logé en rotation, magnétiquement influençable peut être maintenu par complémentarité de force dans sa première et/ou dans sa deuxième position pivotée.
